# EUROPÄISCHE PATENTSCHRIFT

(11) **EP 1 725 775 B1**
(45) Veröffentlichungstag und Bekanntmachung des Hinweises auf die Patenterteilung: **15.10.2008**
(21) Anmeldenummer: 05707390.0
(22) Anmeldetag: 15.02.2005
(51) Int. Cl.: F04D 25/06, F04D 13/02, F04D 29/60, F04D 29/04, H02K 7/08, H02K 5/16, H02K 7/14, H01L 23/473, G06F 1/20

(54) **ANORDNUNG MIT EINEM ELEKTRONISCH KOMMUTIERTEN AUSSENLÄUFERMOTOR**
ARRANGEMENT WITH AN ELECTRONICALLY COMMUTATED EXTERNAL ROTOR MOTOR
ENSEMBLE COMPRENANT UN MOTEUR A INDUIT EXTERIEUR A COMMUTATION ELECTRONIQUE

(30) Priorität: 16.03.2004 DE 202004004442 U
(43) Veröffentlichungstag der Anmeldung: 29.11.2006
(73) Patentinhaber: ebm-papst St. Georgen GmbH & Co. KG, 78112 St. Georgen (DE)
(72) Erfinder: SEIDLER, Siegfried, 78056 Villingen-Schwenningen (DE); ROJO , Francisco, 78112 St. Georgen (DE); LAUFER, Wolfgang, 78733 Aichhalden (DE)
(74) Vertreter: Raible, Tobias
(86) Internationale Anmeldenummer: PCT/EP2005/001491
(87) Internationale Veröffentlichungsnummer: WO 2005/095802

(56) Entgegenhaltungen:
- EP-A- 1 314 894
- DE-A- 4 238 132
- DE-T2- 60 006 989
- FR-A- 2 598 047
- US-B1- 6 208 512
- US-B1- 6 600 649
- PATENT ABSTRACTS OF JAPAN Bd. 2000, Nr. 13, 5. Februar 2001 (2001-02-05) -& JP 2000 274399 A (SANKYO SEIKI MFG CO LTD), 3. Oktober 2000 (2000-10-03)
- PATENT ABSTRACTS OF JAPAN Bd. 014, Nr. 081 (M-0935), 15. Februar 1990 (1990-02-15) -& JP 01 294990 A (MATSUSHITA ELECTRIC IND CO LTD), 28. November 1989 (1989-11-28)
- PATENT ABSTRACTS OF JAPAN Bd. 018, Nr. 628 (M-1713), 30. November 1994 (1994-11-30) & JP 06 241185 A (DAIYU KOGYO KK), 30. August 1994 (1994-08-30)
- PATENT ABSTRACTS OF JAPAN Bd. 1997, Nr. 10, 31. Oktober 1997 (1997-10-31) -& JP 09 163675 A (JIDOSHA DENKI KOGYO CO LTD), 20. Juni 1997 (1997-06-20)
- PATENT ABSTRACTS OF JAPAN Bd. 006, Nr. 201 (M-163), 13. Oktober 1982 (1982-10-13) -& JP 57 108492 A (MORIYAMA KAZUYOSHI), 6. Juli 1982 (1982-07-06)
- PATENT ABSTRACTS OF JAPAN Bd. 014, Nr. 209 (M-968), 27. April 1990 (1990-04-27) -& JP 02 045691 A (MATSUSHITA ELECTRIC IND CO LTD), 15. Februar 1990 (1990-02-15)

## Beschreibung

Die Erfindung betrifft eine Anordnung mit einem elektronisch kommutierten Außenläufermotor.

Derartige Motoren werden wegen ihrer einfachen Bauweise, ihrer hohen Zuverlässigkeit und langen Lebensdauer heute für die verschiedensten Antriebsaufgaben verwendet.

Typische Anwendungen sind der Antrieb von so genannten Gerätelüftern, wie man sie zur Wärmeabfuhr aus Rechnergehäusen verwendet, ebenso der Antrieb von kleinen Lüftern zur direkten Kühlung von Mikroprozessoren, ebenso der Antrieb von Staubsaugern, etc.

Wird ein solcher Außenläufermotor für kombinierte Antriebsaufgaben verwendet, so besteht das Problem, dass man zwar eine kompakte Bauweise anstrebt, dass aber andererseits der Motor nicht durch ein anzutreibendes Teil beeinträchtigt werden darf. Treibt dieser Motor z.B. eine Flüssigkeitspumpe oder eine Kompressor an, so darf kein Medium aus Pumpe oder Kompressor in den Motor gelangen, da dieses Medium sonst die Elektronik des Motors beschädigen oder in diesem Rost und dergleichen verursachen könnte.

Es ist aus JP 06 241 185 eine Anordnung bekannt, mit einem elektronisch kommutierten Aussenläufermotor mit einer Rotorglocke und mit einer Magnetkupplung, wobei ein Trennelement den zweiten Rotor flüssigkeitsdicht vom Aussenläufermotor trennt.

Die Patentschrift JP 2000 274 399 zeigt eine Anordnung mit einem elektronisch kommutierten Aussenläufermotor jedoch ohne Magnetkupplung.

Weiterhin ist es aus JP 01 294 990 eine Anordnung bekannt mit einer Magnetkupplung aber mit einem Innenläufermotor.

Es ist deshalb eine Aufgabe der Erfindung, eine neue Anordnung der eingangs genannten Art bereit zu stellen.

Nach der Erfindung wird diese Aufgabe gelöst durch den Gegenstand des Anspruchs 1. Man erhält so eine kompakte Bauweise, wobei das nichtferromagnetische Trennelement neben seiner Aufgabe der magnetischen und mechanischen Trennung im zweiten Luftspalt zusätzlich auch als Träger der Welle für die Lagerung des zweiten Rotors und als Träger für das Lagerrohr des Außenläufermotors fungieren kann. Dies ermöglicht eine Bauweise mit wenigen Teilen und eine einfache, preiswerte Montage. Ferner ermöglicht es enge Fertigungstoleranzen und, daraus resultierend, einen ruhigen Lauf und eine lange Lebensdauer.

Ein wesentlicher Aspekt der Erfindung ist die Erhöhung der Integrität der Einheit von Außenläufermotor, Magnetkupplung und angetriebenem Element, z.B. Pumpe oder Kompressor. Dies geschieht durch konsequente Anwendung moderner technischer Möglichkeiten zwecks Erreichung minimierter Herstellkosten, hoher Prozesssicherheit bei der Herstellung, minimierter Unwucht besonders des Außenrotors aber auch des zweiten Rotors, sowie Minimierung der Teileanzahl und der Fertigungskosten.

Weitere Einzelheiten und vorteilhafte Weiterbildungen der Erfindung ergeben sich aus dem im Folgenden beschriebenen und in der Zeichnung dargestellten, in keiner Weise als Einschränkung der Erfindung zu verstehenden Ausführungsbeispiel, sowie aus den Unteransprüchen. Es zeigt:
- Fig. 1: einen etwa doppelt vergrößerten Längsschnitt durch eine Anordnung nach einer bevorzugten Ausführungsform der Erfindung, gesehen in Richtung der Linie I-I der Fig. 2,
- Fig. 2: eine Draufsicht, gesehen in Richtung des Pfeils II der Fig. 1,
- Fig. 3: eine Variante zu Fig. 2, bei der statt einer Zentrifugalpumpe ein Verdichter 99 verwendet wird, z.B. eine Kolbenpumpe,
- Fig. 4: eine erste Darstellung zur Erläuterung, wie die Wälzlager des Außenrotors bei der Anordnung nach Fig. 1 und 2 montiert werden,
- Fig. 5: eine zweite Darstellung, welche die Lager in einem Zustand kurz vor Abschluss der Montage zeigt,
- Fig. 6: eine Darstellung, welche zeigt; wie ein Gleitlager von einer Seite des Motors 20 her montiert werden kann, und
- Fig. 7: eine Einzelheit der Fig. 6, die dort mit VII bezeichnet ist.

In der nachfolgenden Beschreibung beziehen sich die Begriffe links, rechts, oben und unten auf die jeweilige Figur. Gleiche oder gleich wirkende Teile werden in den verschiedenen Figuren mit denselben Bezugszeichen bezeichnet, ggf. mit einem nachgestellten Apostroph, z.B. 26' statt 26, und werden gewöhnlich nur einmal beschrieben.

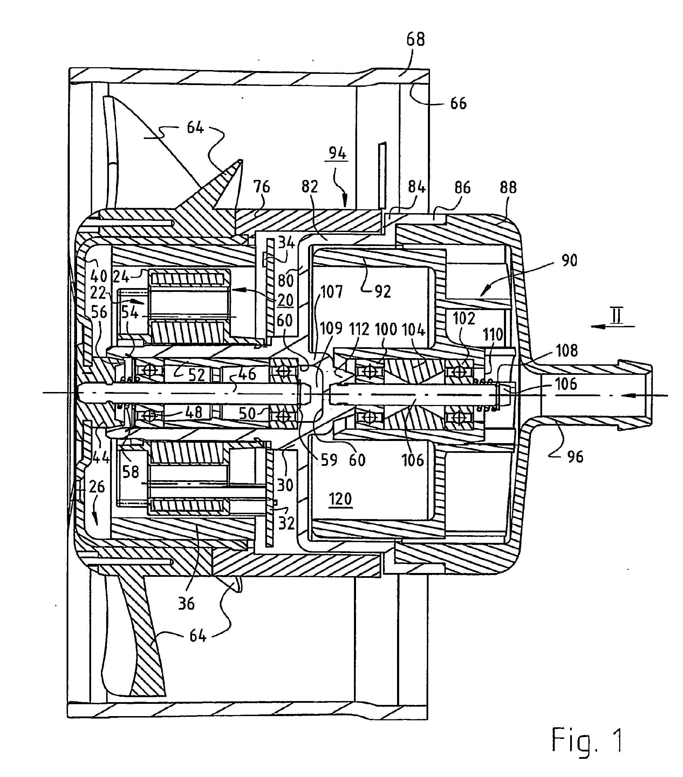

**Fig. 1** zeigt in etwa zweifacher Vergrößerung eine Anordnung mit einem elektronisch kommutierten Außenläufermotor 20. Dieser hat einen Innenstator 22 von konventioneller Bauweise, z.B. einen Stator mit ausgeprägten Polen oder einen Klauenpolstator, und dieser ist durch einen im Wesentlichen zylindrischen Luftspalt 24 von einem Außenrotor 26 getrennt. Im Betrieb dreht sich der Außenrotor 26 um den Innenstator 22, weshalb man solche Motoren 20 als Außenläufermotoren bezeichnet.

Der Innenstator 22 ist auf einem Lagerrohr 30 befestigt, gewöhnlich durch Aufpressen. Rechts vom Innenstator 22 befindet sich eine Leiterplatte 32. Auf dieser befinden sich die (hier nicht dargestellten) elektronischen Bauteile, die man zur elektronischen Kommutierung des Motors 20 benötigt, außerdem ein Rotorstellungssensor 34, der von einem Permanentmagnetring 36 des Außenrotors 26 gesteuert wird. Der Magnetring 36 ist radial magnetisiert und hat bevorzugt vier Rotorpole. Der Sensor 34 wird von einem Streufeld dieses Magnetrings 36 gesteuert, was eine berührungslose Erfassung der Stellung des Rotors 26 ermöglicht.

Der Außenrotor 26 hat eine Bauweise mit einer so genannten Rotorglocke 40, die hier als tiefgezogenes, becherförmiges Blechteil aus weichferromagnetischem Material ausgebildet ist. Der Magnetring 36 ist in diesem Blechteil 40 befestigt, so dass letzteres einen magnetischen Rückschluss für den Rotormagneten 36 bildet.

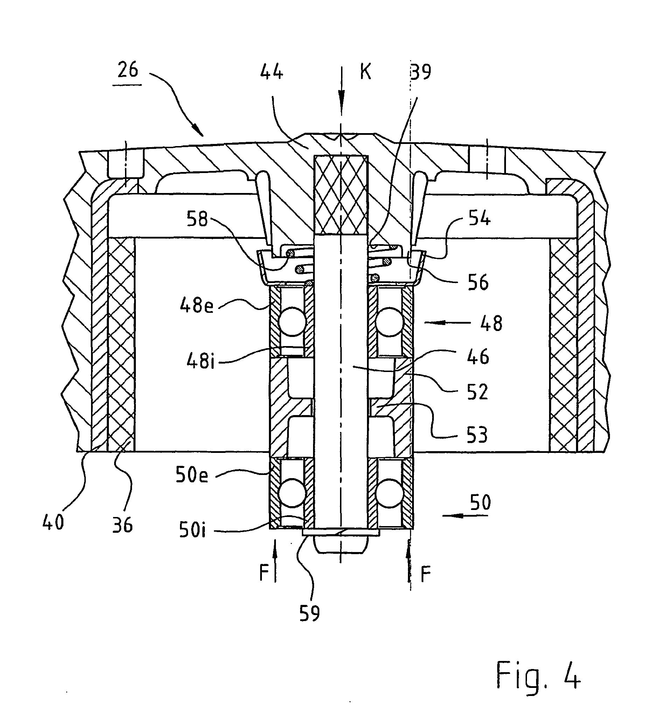

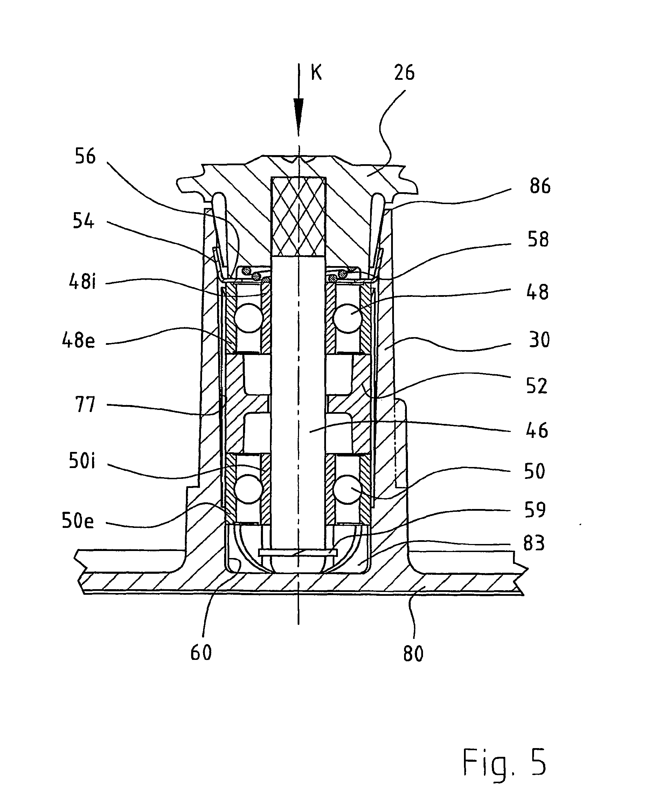

Das Blechteil 40 hat eine Nabe 44, in der eine Welle 46 in der dargestellten Weise befestigt ist. Sie ist in zwei Kugellagern 48, 50 gelagert, deren Außenringe durch ein Distanzstück 52 im Abstand voneinander gehalten werden, vgl. auch die schematischen Darstellungen in den Fig. 4 und 5. Diese Kugellager 48, 50 werden, zusammen mit der Welle 46, bei der Montage von links in das Lagerrohr 30 eingepresst und durch ein Rastglied 54 dort festgehalten. Zum Einpressen des Rastglieds 54 dient ein axialer Vorsprung 56 des Flanschteils 44. Zwischen letzterem und dem Innenring des Wälzlagers 48 befindet sich eine Druckfeder 58, die nach der Montage den Rotor 26 so weit nach links presst, bis ein am rechten Ende der Welle 46 befestigter Sprengring 59 gegen den Innenring des Wälzlagers 50 anliegt. Die Welle 46 ist also in den Innenringen der beiden Wälzlager 48, 50 verschiebbar.

Diese Art der Befestigung ermöglicht es, den Rotor 26 samt seinen fertig vormontierten Lagern 48, 50 von links her im Lagerrohr 30 zu montieren, so dass das rechte Ende 60 der Innenausnehmung des Lagerrohrs 30 wie dargestellt flüssigkeitsdicht verschlossen sein kann. Anhand der nachfolgenden Figuren wird diese Art der Befestigung noch näher erläutert.

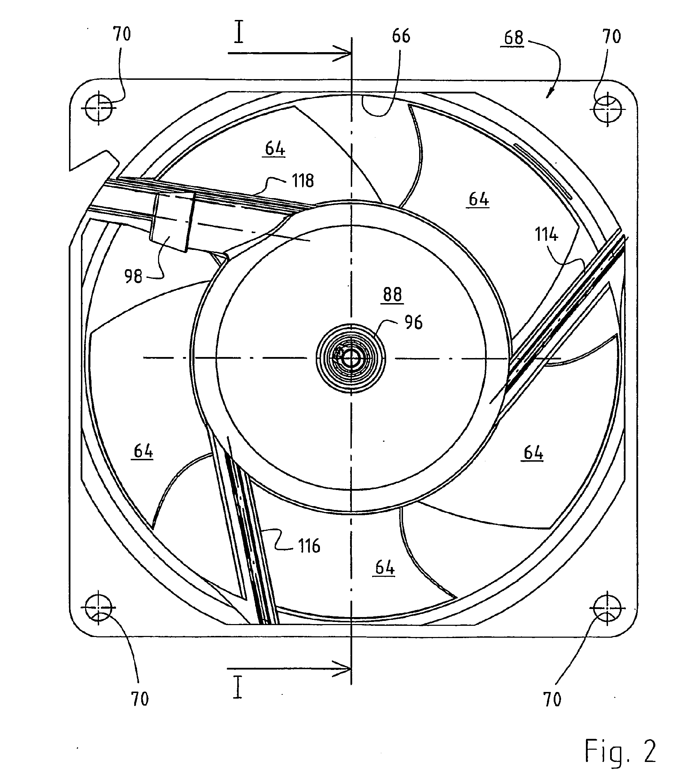

Auf der Außenseite des Blechteils 40 sind durch Kunststoffspritzguss Lüfterflügel 64 in der dargestellten Weise angebracht. Diese drehen sich im Betrieb in einer Ausnehmung 66 eines Lüftergehäuses 68, vgl. **Fig. 2****.** Das Lüftergehäuse 68 hat z.B. die übliche quadratische Form eines Gerätelüfters und hat in seinen Ecken jeweils eine Befestigungsbohrung 70.

Ferner ist auf der Außenseite des Blechteils 40 ein ringförmiger Fortsatz 76 aus einem Kunststoffmaterial mit eingebetteten Partikeln aus Hartferriten durch Kunststoffspritzen befestigt. Man bezeichnet das als einen kunststoffgebundenen Ferritmagneten, aus dem auch der Rotormagnet 36 hergestellt sein kann.

Dieser Ferritmagnet 76 wird in einem entsprechenden Spritzgießwerkzeug hergestellt, und in einem zweiten Prozessschritt kann, ggf. im gleichen Spritzgießwerkzeug, das eigentliche Lüfterrad mit seinen Flügeln 64 um das Bauteil 40 gespritzt werden. Ein solches Verfahren wird als 2K-Verfahren bezeichnet (2K = zwei Kunststoffe). Mit diesem Verfahren lassen sich in besonders vorteilhafter Weise die Herstellkosten, die erreichbare "ursprüngliche Unwucht", die Zahl der Prozessschritte sowie der logistische Aufwand für die Herstellung, minimieren. Alternativ könnte auch ein Hartferrit-Magnetring separat am Blechteil 40 befestigt werden, z.B. durch Kleben oder Aufpressen.

Das Lagerrohr 30 geht nach rechts über in einen flanschartigen Abschnitt 80, der senkrecht zur Drehachse des Rotors 26 verläuft und an seiner Peripherie übergeht in einen zylindrischen Abschnitt 82, der hier die Funktion eines so genannten Spaltrohres hat und deshalb im folgenden als Spaltrohr 82 bezeichnet wird. Das rechte Ende des Ferritmagneten 76 erstreckt sich um die Außenseite des Spaltrohres 82 und parallel zu dieser.

Das Spaltrohr 82 geht über eine Schulter 84 über in einen zylindrischen Abschnitt 86, der, wie dargestellt, zur Befestigung eines Deckels 88 dient, z.B. mittels einer (nicht dargestellten) Schraubenbefestigung, eines (nicht dargestellten) Dichtrings, oder durch Laserschweißen. Der Deckel 88 kann auch als Spiralgehäuse 88 bezeichnet werden, weil sich in seinem Inneren eine spiralförmige Gehäusekontur befindet. In dieser ist ein Förderrad 90 angeordnet.

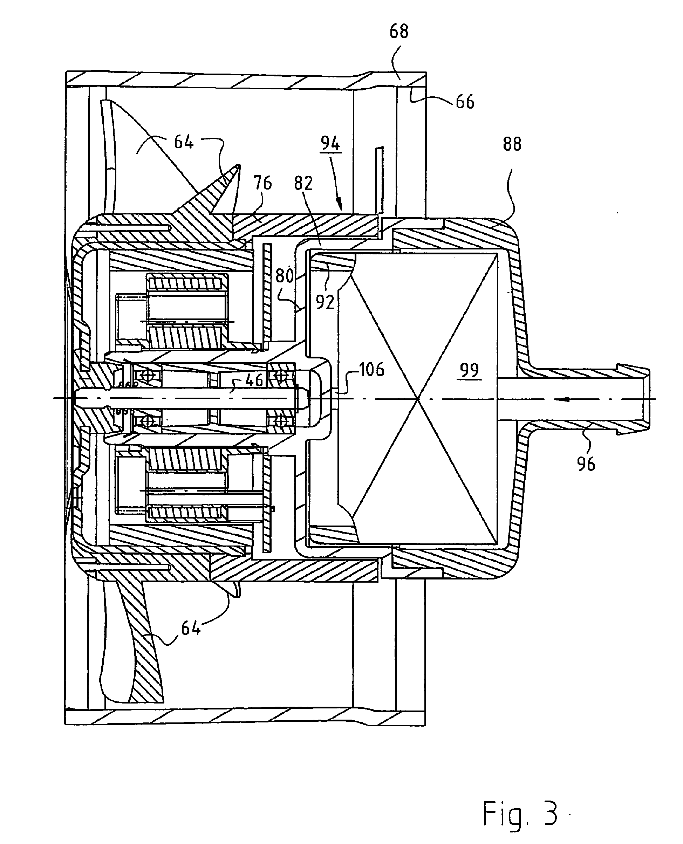

Letzteres ist bevorzugt einstückig mit einem permanentmagnetischen Rotor 92 ausgebildet, der durch das Spaltrohr 82 vom Ferritmagneten 76 getrennt ist und mit diesem eine Magnetkupplung 94 bildet, d.h. wenn sich der Ferritmagnet 76 dreht, dreht sich auch der Rotor 92 und treibt dadurch das Förderrad 90 an, wodurch dieses Flüssigkeit über einen Einlass 96 ansaugt und über eine Auslass 98 (Fig. 2) nach außen pumpt. Selbstverständlich kann anstelle einer Spiralpumpe jedes beliebige andere anzutreibende Aggregat vorgesehen werden, z.B. ein Kompressor 99 für ein Kältemittel, wie das **Fig. 3** zeigt. Auch der Kompressor 99 wird über eine Magnetkupplung 94 angetrieben, die gleich aufgebaut sein kann wie die der Fig. 1.

Der permanentmagnetische Rotor 92 ist mittels zweier Wälzlager 100, 102, zwischen deren Außenringen sich ein Distanzglied 104 befindet, auf einer stationären Welle 106 drehbar gelagert, welche in einem nach rechts ragenden Vorsprung 107 des Abschnitts 80 in der dargestellten Weise flüssigkeitsdicht befestigt ist. Am rechten Ende der Welle 106 ist ein Sprengring 108 befestigt, und zwischen diesem und dem Innenring des Wälzlagers 102 befindet sich eine Druckfeder 110, welche den beiden Wälzlagern 100, 102 eine axiale Vorspannung erteilt. Der Innenring des linken Wälzlagers 100 ist an einem axialen Vorsprung 112 des Vorsprungs 107 abgestützt. Auf seiner linken Seite ist der Vorsprung 107 hohl und bildet dort das rechte Ende 60 der Innenausnehmung des Lagerrohres 30. Für die dargestellte Art der Befestigung der Lager 48, 50 benötigt man einen freien Raum 109 zwischen dem rechten Ende der Welle 46 und dem Boden der Ausnehmung 60, und die Ausgestaltung mit dem Vorsprung 107 ermöglicht trotz dieses freien Raumes 109 eine axial kompakte Bauweise, bei der der Raum im Aggregat gut ausgenützt wird.

Der zylindrische Abschnitt 86 ist über Stege 114, 116, 118 mit dem Lüftergehäuse 68 verbunden, so dass dieses mit dem Spaltrohr 82, dem Abschnitt 80 und dem Lagerrohr 30 ein einstückiges Teil bildet, was die Montage der Anordnung sehr vereinfacht, die Zahl der Teile klein hält, und die verwendeten Aggregate sicher voneinander trennt, so dass Flüssigkeit vom Spiralrad 90 nicht zum Motor 20 gelangen und diesen schädigen kann. Die stationäre Welle 106 bildet ebenfalls einen Bestandteil dieses Spritzgießteils, weil sie in diesem bei der Herstellung verankert wird und trägt deshalb ebenfalls zur kompakten Bauweise bei.

### Arbeitsweise

Im Betrieb treibt der Außenläufermotor 20 den Außenrotor 26 an, so dass sich die Lüfterflügel 64 im Gehäuse 68 drehen und dadurch in diesem in bekannter Weise einen axialen Luftstrom erzeugen. Alternativ kann der Lüfter z.B. auch als Diagonallüfter oder Radiallüfter ausgebildet werden. Dargestellt ist ein Axiallüfter. Die verwendete Lüfterbauweise hängt von den Anforderungen ab.

Gleichzeitig treibt der Ferritmagnetring 76, der z.B. sechs- oder achtpolig magnetisiert sein kann, durch das Spaltrohr 82 hindurch den Rotormagneten 92 an, der in diesem Fall ebenfalls sechs- oder achtpolig magnetisiert sein wird, und dreht so das Förderrad 90, so dass dieses Flüssigkeit durch den Einlass 96 ansaugt und durch den Auslass 98 (Fig. 2) nach außen pumpt. Z.B. kann eine solche Anordnung verwendet werden, um in einem Springbrunnen Wasser anzusaugen und nach außen zu pumpen, oder um in einer Herz-Lungen-Maschine Blut zu pumpen, oder um Kühlflüssigkeit in einem geschlossenen Kühlkreislauf zu transportieren, wobei das Förderrad 90 dann die Funktion einer Umwälzpumpe hat.

Da der Deckel 88 flüssigkeitsdicht mit dem Spaltrohr 82 verbunden ist, z.B. durch Laserschweißen, kann aus dem Gehäuse 88 keine Flüssigkeit nach außen entweichen, wozu vor allem beiträgt, dass der flanschartige Abschnitt 80 und sein Vorsprung 107 frei von Durchbrechungen jeder Art sind. Dies ist deshalb möglich, weil der Außenrotor 26, z.B. in der nachfolgend bei Fig. 4 und 5 beschriebenen Weise, von links her sicher montiert werden kann, weil es nicht notwendig ist, während der Montage zum rechten Ende der Welle 46 Zugriff zu haben. Ebenso kann das Förderrad 90 der Zentrifugalpumpe mit seinen Lagern 100, 102 von rechts her auf der stationären Welle 106 montiert und durch den Sprengring 108 gesichert werden, bevor der Deckel 88 befestigt wird.

Für die Lager 100, 102 verwendet man bevorzugt so genannte Hybridlager. Diese haben Kugeln aus Keramik und Lagerringe aus einer korrosionsresistenten Edelstahllegierung. Sie werden z.B. von der Firma GRW hergestellt und werden besonders für Blutpumpen und Dentalbohrer verwendet. Mit solchen Lagern erhält man die gewünschten Lebensdauern auch in ungewöhnlichen Medien.

Alternativ zu Fig. 1 kann man für die Lagerung des Förderrads 90 eine rotierende Welle vorsehen, die genauso wie die Welle 46 des Motors 20 in einem (nicht dargestellten) Lagerrohr gelagert wird, das dann - ebenso wie das Lagerrohr 30 - einstückig mit dem Abschnitt 80 ausgebildet wird und von diesem nach rechts ragt, also spiegelbildlich zum Lagerrohr 30. Die Montage erfolgt bei dieser Variante in gleicher Weise, wie das für die Montage des Außenrotors 26 beschrieben wurde, also durch Einpressen in dieses (nicht gezeigte) Lagerrohr. Eine solche Montage geht schneller als die Montage der Feder 110 und des Sprengrings 108 bei der Version nach Fig. 1, weil die Vormontage in diesem Fall außerhalb der Pumpe in einer speziellen Vorrichtung erfolgen und weitgehend automatisiert sein kann.

Auch kann in diesem Fall der Stator 22 des Außenläufermotors 20 fluiddicht versiegelt sein. Dies kann geschehen durch Umgießen mit Polyurethan oder mit Hotmelt. In diesem Fall kann der Stator in dem in Fig. 1 mit 120 bezeichneten Hohlraum auf dem im vorhergehenden Absatz beschriebenen Lagerrohr (gemäß Variante) befestigt werden und direkt den Rotor 92 der Magnetkupplung 94 antreiben. Das Lüfterrad 64 wird in diesem Fall über eine Magnetkupplung angetrieben, d.h. der Magnetring 76 treibt in diesem Fall direkt die Flügel 64 des Lüfters an. Dies ermöglicht eine noch kompaktere Bauweise, da der Hohlraum 120 in diesem Fall vom Innenstator des Außenläufermotors ausgefüllt wird. Es ist dann auch möglich, das Lüfterrad 64 an seinem Außenumfang in einem Lager direkt im Gehäuse 68 zu lagern, wie das gelegentlich bei solchen Lüftern praktiziert wird. Damit ergibt sich dann eine außerordentlich kurze Bauweise, wie sie in manchen Geräten gefordert wird. In diesem Fall sind die Flügel 64 an ihrer Peripherie durch einen Ring verbunden.

Gemäß **Fig. 4****,** die sich geringfügig von Fig. 1 unterscheidet, werden vor dem Zusammenbau des Motors 20 auf der Welle 46 verschiedene Bauelemente vormontiert.

Beginnend bei dem Vorsprung 56 ist das zunächst die Druckfeder 58 von bevorzugt kegeliger Gestalt, deren Ende größeren Durchmessers in einer Vertiefung 39 liegt.

Auf die Feder 58 folgt nach unten das ringförmige Sicherungsglied in Form der Sicherungsscheibe 54. Die Feder 58 liegt bevorzugt nicht gegen dieses Sicherungsglied 54 an.

Auf das Sicherungsglied 54 folgt das Wälzlager 48 mit seinem Außenring 48e und seinem Innenring 48i. Letzterer ist auf der Welle 46 in axialer Richtung verschiebbar. Das untere Ende der Feder 58 liegt gegen das obere Ende des Innenrings 48i an. Auf das Wälzlager 48 folgt das Distanzstück 52, das mittels eines radial nach innen ragenden Vorsprungs 53 auf der Welle 46 verschiebbar geführt ist, und dessen oberes Ende, wie dargestellt, gegen das untere Ende des Außenrings 48i anliegt.

Auf das Distanzstück 52 folgt das untere Wälzlager 50 mit seinem Außenring 50e, der mit seinem oberen Ende gegen das Distanzstück 52 anliegt, und mit seinem

Innenring 50i, welcher auf der Welle 46 in axialer Richtung verschiebbar ist und mit seinem unteren Ende wie dargestellt gegen den Sprengring 59 anliegt, wenn der Motor 20 fertig montiert ist.

Wie man ohne weiteres erkennt, kann man, wenn man mit einer Kraft F nach oben auf das untere Wälzlager 50 drückt, die Feder 58 zusammenpressen und dabei die beiden Lager 48, 50, das Distanzstück 52 und die Sicherungsscheibe 54 nach oben auf der Welle 46 verschieben, so dass der Innenring 50i nicht mehr gegen den Sprengring 59 anliegt, sondern einen Abstand von ihm bekommt. In diesem Fall kommt der Vorsprung 56 des Rotors 22 zur Anlage gegen die Sicherungsscheibe 54 und ermöglicht es, über diese eine axiale Kraft in distaler Richtung auf die Sicherungsscheibe 54, den Außenring 48e, das Distanzstück 52 und den Außenring 50e zu übertragen, wenn der Rotor 26 durch eine Kraft K bei der Montage nach unten gepresst wird. Dies ist nachfolgend in Fig. 5 dargestellt.

**Fig. 5** zeigt sozusagen eine Momentaufnahme bei dem Vorgang der "Verheiratung", bei dem die Welle 46 des Rotors 26 mit den darauf befindlichen Wälzlagern 48, 50 erstmals in die Innenausnehmung 77 des Lagerrohres 30 eingeführt wird.

Hierbei wird eine Kraft K in axialer Richtung auf den Rotor 26 aufgebracht, und da die Außenringe 48e, 50e der Wälzlager 48, 50 mit Presssitz in Rippen des Lagerrohres 30 eingepresst werden, wird die Feder 58 durch die Kraft K zusammengepresst, so dass sich die Welle 46 in den Kugellagern 48, 50 in distaler Richtung verschiebt, und der Vorsprung 56 über die Sicherungsscheibe 54 den Außenring 48e des Kugellagers 48 und über das Distanzglied 52 auch den Außenring 50e des Kugellagers 50 beaufschlagt und so die beiden Kugellager 48, 50 in das Lagerrohr 30 einpresst. Wie in Fig. 5 dargestellt, wird hierbei die Feder 58 nur teilweise zusammen gepresst, um ihre Beschädigung zu vermeiden.

Das Einpressen setzt sich so lange fort, bis der Außenring 50e des unteren Kugellagers 50 gegen das obere Ende von Rippen 83 anliegt, die im Lagerrohr 30 an dessen innerem Ende 60 vorgesehen sind.

Hierbei verschiebt sich, wie dargestellt, das Sicherungsglied 54 im Lagerrohr 30 nach unten und gräbt sich dabei in das Kunststoff-Material des Lagerrohres 30 ein, so dass es die gesamte Lageranordnung im Lagerrohr 30 verrastet/verriegelt. Würde man versuchen, entgegen der Kraft K den Rotor 26 aus dem Lagerrohr 30 herauszuziehen, so würde sich das Sicherungsglied 54 nur umso tiefer in das Material des Lagerrohres 30 eingraben, d.h. es handelt sich um eine außerordentlich sichere Befestigung. Naturgemäß gibt es für eine solche permanente Verrastung viele verschiedene Lösungen und Bauelemente, und das dargestellte Sicherungselement 54 stellt deshalb nur eine bevorzugte Ausführungsform dar.

Nach dem vollständigen Einpressen wird die Kraft K weggenommen, und es ergibt sich dann das Bild nach Fig. 1, d.h. die Feder 58 drückt nun die Welle 46 wieder so weit, bis der Sprengring 59 wieder gegen den Innenring 50i des Wälzlagers 50 anliegt. "Die Verheiratung" ist dann abgeschlossen. Die Feder 58 verspannt jetzt die beiden Innenringe 48i, 50i der Wälzlager 48, 50 gegeneinander, was für einen ruhigen Lauf des Motors 20 förderlich ist.

Wie bereits ausgeführt, lässt sich die gleiche Art der Befestigung auch bei der Montage des Förderrads 90 anwenden, wobei dann auch für das Förderrad ein entsprechendes Lagerrohr vorgesehen werden muss, was eine (nicht dargestellte) Alternative zu Fig. 1 darstellt.

Der große Vorteil bei dieser Art der Befestigung ist, dass gemäß Fig. 4 die Kugellager 48, 50, das Distanzglied 52 und der Sprengring 59 in der Weise vormontiert werden können, wie das Fig. 4 zeigt. Die vormontierten Teile können anschließend auf sichere Funktion geprüft werden, und wenn dies geschehen ist, kann der vormontierte Rotor 26 (oder das vormontierte Förderrad 90) einfach in das zugehörige Lagerrohr eingepresst werden, wobei weitere Montagearbeiten entfallen. Dies ist also eine sehr einfache Art der Befestigung, welche zu einer besonders kompakten Bauweise des Aggregats beiträgt.

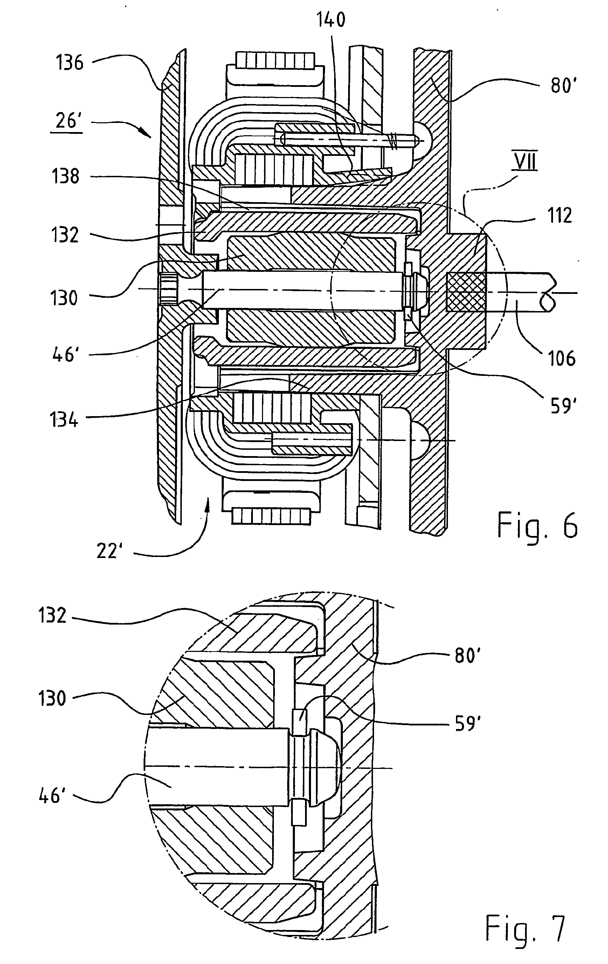

Die **Fig. 6** und **Fig. 7** zeigen eine analoge Art der Rotorbefestigung bei einem Außenläufermotor 20', dessen Welle 46' in einem Sinter-Doppellager 130 gelagert ist. Letzteres ist in ein Lagerrohr 132 in einer vorgegebenen axialen Stellung eingepresst, und der Außenrotor 26' wird in der Weise vormontiert, dass auf seine Welle 46' das Sinterlager 130 zusammen mit dem Lagerrohr 132 aufgeschoben und anschließend durch den Sprengring 59' gesichert wird.

Man erhält dann einen vormontierten Rotor etwa analog Fig. 4, aber nicht mit Kugellagern, sondern mit einem Gleitlager 130, das sich in dem Lagerrohr 132 an einer vorgegebenen axialen Stellung befindet.

Am Abschnitt 80' (aus Kunststoff) ist ein Lagerrohr-Stutzen 134 vorgesehen. Dieser ist bevorzugt einstückig mit dem Abschnitt 80' ausgebildet. Der Stutzen 134 erstreckt sich nur etwa über die halbe Distanz zwischen dem Abschnitt 80' und dem Boden 136 der Rotorglocke 26'.

In diesem Stutzen 134 wird gemäß Fig. 6 und 7 der fertig mit dem Gleitlager 130 vormontierte Außenrotor 26' mit seinem Lagerrohr 132 eingepresst. Letzteres hat auf seiner Außenseite Rippen 138, die beim Einpressen verformt werden und dadurch einen sicheren Sitz und eine sichere Befestigung bewirken.

Wie Fig. 6 zeigt, wird anschließend noch der Spulenkörper 140 des Innenstators 22' über das Lagerrohr 132 und den Lagerrohr-Stutzen 134 geschoben und bewirkt eine zusätzliche Sicherung.

Auf diese Weise kann auch ein Rotor 26', der mit einem Gleitlager 130 versehen ist, bequem vormontiert und anschließend im vormontierten Zustand durch Einpressen von einer Seite im Lüfter befestigt werden. Die gleiche Art der Befestigung ist selbstverständlich auch für das Förderrad 90 möglich, sofern das Gleitlager 130 mit dem dort geförderten Fluid kompatibel ist.

Naturgemäß sind im Rahmen der vorliegenden Erfindung vielfache Abwandlungen und Modifikationen möglich.

## Patentansprüche

1. Anordnung mit einem elektronisch kommutierten Außenläufermotor (20), welcher einen Innenstator (22; 22') aufweist, der auf einem Lagerrohr (30; 134) angeordnet ist und der durch einen ersten Luftspalt (24) von einem Außenrotor (26; 92) getrennt ist, welch letzterer eine Rotorglocke (40) aufweist, die an einem Ende offen und an ihrem anderen Ende mit einer Welle (46; 46') verbunden ist,
ferner mit einer am offenen Ende der Rotorglocke (40) angeordneten Permanentmagnetanordnung (76) zur Wechselwirkung mit einem in der Anordnung drehbar gelagerten zweiten permanentmagnetischen Rotor (92), welche Permanentmagnetanordnung (76) von diesem zweiten Rotor (92) durch einen zweiten Luftspalt getrennt ist und mit dem zweiten Rotor (92) eine Magnetkupplung (94) bildet, so dass eine Drehung der Permanentmagnetanordnung (76) eine Drehung dieses zweiten Rotors (92) bewirkt,
und mit einem in dem zweiten Luftspalt angeordneten, nichtferromagnetischen Trennelement (80, 80', 82),
- welches den zweiten Rotor (92) flüssigkeitsdicht vom Außenläufermotor (20) trennt
- und an welchem eine Anordnung (106) für die Lagerung des zweiten Rotors (92) und das Lagerrohr (30; 134) für die Lagerung der Welle (46; 46') der Rotorglocke (40) angeordnet sind,
wobei das Trennelement (80, 80', 82) das Lagerrohr (30; 134) an dessen von der Rotorglocke (40) abgewandtem Ende flüssigkeitsdicht verschließt,
und die Welle (46; 46') der Rotorglocke (40) in dem Lagerrohr (30; 134) gegen Abziehen gesichert (54, 59; 59') gelagert ist.

2. Anordnung nach Anspruch 1, bei welcher der Außenläufermotor (20) als Antriebsmotor eines Lüfters ausgebildet und auf der Peripherie seines Außenrotors (26) mit Lüfterflügeln (64) für diesen Lüfter versehen ist.

3. Anordnung nach Anspruch 2, bei welcher die Lüfterflügel (64) durch Kunststoffsoritzen mit der Rotorglocke (40) verbunden sind.

4. Anordnung nach einem der vorhergehenden Ansprüche, bei welcher die am offenen Ende der Rotorglocke (40) angeordnete Permanentmagnetanordnung (76) kunststoffgebundenes Magnetmaterial aufweist.

5. Anordnung nach Anspruch 4, bei welcher das kunststoffgebundene Magnetmaterial (76) durch Kunststoffspritzen mit der Rotorglocke (40) verbunden ist.

6. Anordnung nach den Ansprüchen 3 und 5, bei welcher die Permanentmagnetanordnung (76) aus kunststoffgebundenem Magnetmaterial und die Lüfterflügel (64) im so genannten 2K-Verfahren in aufeinander folgenden Prozessschritten hergestellt sind.

7. Anordnung nach einem der vorhergehenden Ansprüche, bei welcher das nichtferromagnetische Trennelement (80, 82, 84) aus Kunststoff hergestellt ist.

8. Anordnung nach einem der vorhergehenden Ansprüche, bei welcher das nichtferromagnetische Trennelement (80, 82, 84) etwa topfartig ausgebildet ist und auf seiner dem Außenläufermotor (20) zugewandten Seite keinen Flüssigkeitsdurchlass aufweist.

9. Anordnung nach einem der vorhergehenden Ansprüche, bei welcher am Außenrotor (26) Lüfterflügel (64) angeordnet sind, welche im Betrieb innerhalb eines Lüftergehäuses (68) rotieren,
und bei welcher das Lüftergehäuse (68) über eine Mehrzahl von Stegen (114, 116, 118) mit dem nichtferromagnetischen Trennelement (80, 82, 84) verbunden ist.

10. Anordnung nach einem der vorhergehenden Ansprüche, bei welcher das nichtferromagnetische Trennelement (80, 82, 84) auf seiner vom Außenläufermotor (20) abgewandten Seite mit einem deckelartigen Teil (88) flüssigkeitsdicht verbunden ist.

11. Anordnung nach einem der vorhergehenden Ansprüche, bei welcher der zweite Rotor (92) mit einem Pumpelement (90; 99) verbunden ist.

12. Anordnung nach Anspruch 11, bei welcher der zweite Rotor (92) mit mindestens einem Teil des Pumpelements (90; 99) einstückig ausgebildet ist.

13. Anordnung nach einem der vorhergehenden Ansprüche, bei welcher ein Förderrad (90) der Pumpe mit einer Welle verbunden ist, welche im Betrieb rotiert und welcher ein Lagerrohr zu ihrer Lagerung zugeordnet ist.

14. Anordnung nach einem der vorhergehenden Ansprüche, bei welcher der Innenstator fluiddicht versiegelt und in dem vom Pumpenrotor (92) geförderten Fluid angeordnet ist, und in direkter Wechselwirkung mit dem Pumpenrotor (92) steht, um diesen im Betrieb anzutreiben.

15. Anordnung nach Anspruch 14, bei welcher der Pumpenrotor (92) über einen Luftspalt mit dem Lüfterrad (64) in Wechselwirkung steht, um dieses nach Art einer Magnetkupplung anzutreiben.

16. Anordnung nach einem der vorhergehenden Ansprüche, bei welcher die Welle (46') des Rotors (26) in einem Sinterlager (130) gelagert ist, welches in einem Trägerrohr (132) befestigt ist, das seinerseits in dem Lagerrohr (134) befestigt ist, das an dem nichtferromagnetischen Trennelement (80', 82) angeordnet ist.

17. Anordnung nach Anspruch 16, bei welcher im Bereich des freien Endes der Welle (46'), das aus dem Sinterlager (130) heraus ragt, ein Sicherungselement (59') vorgesehen ist, welches die Welle (46') gegen ein Herausziehen aus dem Sinterlager (130) sichert.

18. Anordnung nach Anspruch 16 oder 17, bei welcher am freien Ende der Welle (46') eine Kuppe vorgesehen ist.

19. Anordnung nach einem der Ansprüche 14 bis 18, bei welcher der auf dem Lagerrohr (134) angeordnete Innenstator (22') einen Spulenkörper (140) aufweist, welcher als Sicherung für das Trägerrohr (132) ausgebildet ist.

20. Anordnung nach einem der Ansprüche 16 bis 19, bei welcher das Trägerrohr (132) auf seiner Außenseite mit Rippen (138) versehen ist, welche dazu ausgebildet sind, sich beim Einpressen des Trägerrohres (132) in das Lagerrohr (134) zu verformen.

21. Anordnung nach einem der Ansprüche 1 bis 15, bei welcher zur Lagerung der Welle (46) des Rotors (26; 92) Wälzlager (48, 50) vorgesehen sind, zwischen deren Außenringen (48e, 50e) ein Distanzglied (53) angeordnet ist, und innerhalb von deren Innenringen (48i, 50i) diese Welle (46) axial verschiebbar angeordnet ist.

22. Anordnung nach Anspruch 21, bei welcher am freien Ende der Welle (52) ein Sicherungsglied (59) vorgesehen ist, welches im montierten Zustand gegen den Innenring (50i) eines benachbarten Wälzlagers (50) anliegt.

23. Anordnung nach Anspruch 22, bei welcher eine Feder (48) vorgesehen ist, welche das Sicherungsglied (59) mit Vorspannung gegen den Innenring (50i) des benachbarten Wälzlagers (50) drückt.

24. Anordnung nach einem der Ansprüche 21 bis 23, bei welcher der Außenring (48e) eines der Wälzlager (48, 50) durch ein Sicherungselement (54) im Lagerrohr (30) fixiert ist.

## Claims

1. Arrangement with an electronically commutated external rotor motor (20), which has an internal stator (22; 22') which is arranged on a bearing pipe (30; 134) and separated by a first air gap (24) from an external rotor (26; 92), which has a rotor bell (40), which is open at one end and connected at its other end to a shaft (46, 46'),
also with a permanent magnet arrangement (76) which is arranged at the open end of the rotor bell (40), for interaction with a second permanently magnetic rotor (92), which is supported in the arrangement so that it can rotate, said permanent magnet arrangement (76) being separated from this second rotor (92) by a second air gap, and forming a magnetic coupling (94) with the second rotor (92), so that rotation of the permanent magnet arrangement (76) causes rotation of this second rotor (92),
and with a non-ferromagnetic separating element (80, 80', 82) which is arranged in the second air gap,
- which separates the second rotor (92) from the external rotor motor (20) in a liquid-proof manner,
- and on which an arrangement (106) for supporting the second rotor (92) and the bearing pipe (30; 134) for supporting the shaft (46; 46') of the rotor bell (40) are arranged,
the separating element (80, 80', 82) sealing the bearing pipe (30; 134) at its end facing away from the rotor bell (40) in a liquid-proof manner,
and the shaft (46; 46') of the rotor bell (40) being supported in the bearing pipe (30; 134) and secured (54, 59; 59') against pulling off.

2. Arrangement according to Claim 1, wherein the external rotor motor (20) is in the form of a driving motor of a fan, and is provided on the periphery of its external rotor (26) with fan blades (64) for this fan.

3. Arrangement according to Claim 2, wherein the fan blades (64) are joined to the rotor bell (40) by plastic injection.

4. Arrangement according to one of the preceding claims, wherein the permanent magnet arrangement (76) which is arranged at the open end of the rotor bell (40) has plastic-bound magnetic material.

5. Arrangement according to Claim 4, wherein the plastic-bound magnetic material (76) is joined to the rotor bell (40) by plastic injection.

6. Arrangement according to Claims 3 and 5, wherein the permanent magnet arrangement (76) of plastic-bound magnetic material and the fan blades (64) are produced in successive process steps by the so-called 2K method.

7. Arrangement according to one of the preceding claims, wherein the non-ferromagnetic separating element (80, 82, 84) is made of plastic.

8. Arrangement according to one of the preceding claims, wherein the non-ferromagnetic separating element (80, 82, 84) is approximately pot-shaped, and on its side facing the external rotor motor (20) has no way through for liquid.

9. Arrangement according to one of the preceding claims, wherein fan blades (64), which in operation rotate within a fan housing (68), are arranged on the external rotor (26),
and wherein the fan housing (68) is joined to the non-ferromagnetic separating element (80, 82, 84) via multiple fins (114, 116, 118).

10. Arrangement according to one of the preceding claims, wherein the non-ferromagnetic separating element (80, 82, 84) is joined in a liquid-proof manner, on its side facing away from the external rotor motor (20), to a cover-like part (88).

11. Arrangement according to one of the preceding claims, wherein the second rotor (92) is connected to a pump element (90; 99).

12. Arrangement according to Claim 11, wherein the second rotor (92) is formed in one piece with at least a part of the pump element (90; 99).

13. Arrangement according to one of the preceding claims, wherein a conveying wheel (90) of the pump is joined to a shaft, which rotates in operation and with which a bearing pipe is associated to support it.

14. Arrangement according to one of the preceding claims, wherein the internal stator is sealed in a fluid-proof manner and arranged in the fluid which the pump rotor (92) conveys, and interacts directly with the pump rotor (92) to drive it in operation.

15. Arrangement according to Claim 14, wherein the pump rotor (92) interacts with the fan wheel (64) via an air gap, to drive it like a magnetic coupling.

16. Arrangement according to one of the preceding claims, wherein the shaft (46') of the rotor (26) is supported in a porous bearing (130), which is fixed in a carrying pipe (132), which itself is fixed in the bearing pipe (134), which is arranged on the non-ferromagnetic separating element (80', 82).

17. Arrangement according to Claim 16, wherein in the region of the free end of the shaft (46'), which extends out of the porous bearing (130), a securing element (59') is provided, to secure the shaft (46') against being pulled out of the porous bearing (130).

18. Arrangement according to Claim 16 or 17, wherein a cap is provided at the free end of the shaft (46').

19. Arrangement according to one of Claims 14 to 18, wherein the internal stator (22'), which is arranged on the bearing pipe (134), has a coil body (140), which is designed to secure the carrying pipe (132).

20. Arrangement according to one of Claims 16 to 19, wherein the carrying pipe (132) is provided externally with ribs (138), which are designed to deform when the carrying pipe (132) is pressed into the bearing pipe (134).

21. Arrangement according to one of Claims 1 to 15, wherein rolling bearings (48, 50) are provided to support the shaft (46) of the rotor (26; 92), a spacer (53) is arranged between their outer rings (48e, 50e), and this shaft (46) is arranged within their inner rings (48i, 50i) so that it can move axially.

22. Arrangement according to Claim 21, wherein at the free end of the shaft (52) a securing element (59), which in the fitted state lies against the inner ring (50i) of an adjacent rolling bearing (50), is provided.

23. Arrangement according to Claim 22, wherein a spring (48), which presses the securing element (59) against the inner ring (50i) of the adjacent rolling bearing (50) with initial tension, is provided.

24. Arrangement according to one of Claims 21 to 23, wherein the outer ring (48e) of one of the rolling bearings (48, 50) is fixed in the bearing pipe (30) by a securing element (54).

## Revendications

1. Arrangement comprenant un moteur à induit extérieur à commutation électronique (20) qui présente un stator intérieur (22 ; 22') qui est disposé sur un tube palier (30 ; 134) et qui est séparé par un premier entrefer (24) d'un rotor extérieur (26 ; 92), lequel dernier présente une cloche de rotor (40) qui est ouverte à une extrémité et reliée à un arbre (46 ; 46') à son autre extrémité,
comprenant de plus un arrangement d'aimant permanent (76) disposé à l'extrémité ouverte de la cloche de rotor (40) et destiné à interagir avec un deuxième rotor (92) à aimant permanent monté à rotation dans l'arrangement, lequel arrangement d'aimant permanent (76) est séparé de ce deuxième rotor (92) par un deuxième entrefer et forme avec le deuxième rotor (92) un accouplement magnétique (94) de sorte qu'une rotation de l'arrangement d'aimant permanent (76) entraîne une rotation de ce deuxième rotor (92), et comprenant un élément séparateur (80, 80', 82) non ferromagnétique, disposé dans le deuxième entrefer,
- lequel sépare le deuxième rotor (92) du moteur à induit extérieur (20) de manière étanche aux liquides
- et sur lequel sont disposés un arrangement (106) pour le montage du deuxième rotor (92) et le tube palier (30 ; 134) pour le montage de l'arbre (46 ; 46') de la cloche de rotor (40),
l'élément séparateur (80, 80', 82) fermant le tube palier (30 ; 134) de manière étanche aux liquides à son extrémité opposée à la cloche de rotor (40),
et l'arbre (46 ; 46') de la cloche de rotor (40) étant monté dans le tube palier (30 ; 134) de manière assurée contre l'extraction (54, 59 ; 59').

2. Arrangement selon la revendication 1, dans lequel le moteur à induit extérieur (20) est réalisé en tant que moteur d'entraînement d'un ventilateur et pourvu à la périphérie de son rotor extérieur (26) d'ailettes de ventilateur (64) pour ce ventilateur.

3. Arrangement selon la revendication 2, dans lequel les ailettes de ventilateur (64) sont reliées à la cloche de rotor (40) par injection de matière plastique.

4. Arrangement selon l'une des revendications précédentes, dans lequel l'arrangement d'aimant permanent (76) disposé à l'extrémité ouverte de la cloche de rotor (40) présente un matériau magnétique lié par une matière plastique.

5. Arrangement selon la revendication 4, dans lequel le matériau magnétique lié par une matière plastique (76) est relié à la cloche de rotor (40) par injection de matière plastique.

6. Arrangement selon les revendications 3 et 5, dans lequel l'arrangement d'aimant permanent (76) en matériau magnétique lié par une matière plastique et les ailettes de ventilateur (64) sont fabriqués selon le procédé dit à deux composants dans des étapes de processus successives.

7. Arrangement selon l'une des revendications précédentes, dans lequel l'élément séparateur non-ferromagnétique (80, 82, 84) est fabriqué en matière plastique.

8. Arrangement selon l'une des revendications précédentes, dans lequel l'élément séparateur non-ferromagnétique (80, 82, 84) est réalisé à peu près en forme de pot et ne présente pas de passage de liquide sur son côté tourné vers le moteur à induit extérieur (20).

9. Arrangement selon l'une des revendications précédentes, dans lequel sur le rotor extérieur (26) sont disposées des ailettes de ventilateur (64) qui, en fonctionnement, tournent à l'intérieur d'un boîtier de ventilateur (68),
et dans lequel le boîtier de ventilateur (68) est relié à l'élément séparateur non-ferromagnétique (80, 82, 84) par une pluralité de branches ou de ponts (114, 116, 118).

10. Arrangement selon l'une des revendications précédentes, dans lequel l'élément séparateur non-ferromagnétique (80, 82, 84) est relié de manière étanche aux liquides sur son côté opposé au moteur à induit extérieur (20) à une partie (88) de type couvercle.

11. Arrangement selon l'une des revendications précédentes, dans lequel le deuxième rotor (92) est relié à un élément de pompe (90 ; 99).

12. Arrangement selon la revendication 11, dans lequel le deuxième rotor (92) est réalisé d'une seule pièce avec au moins une partie de l'élément de pompe (90 ; 99).

13. Arrangement selon l'une des revendications précédentes, dans lequel une roue de transport (90) de la pompe est reliée à un arbre qui tourne en fonctionnement et auquel est associé un tube palier pour son montage ou support.

14. Arrangement selon l'une des revendications précédentes, dans lequel le stator intérieur est scellé de manière étanche aux fluides et disposé dans le fluide transporté par le rotor de pompe (92), et est en interaction directe avec le rotor de pompe (92) pour entraîner celui-ci en fonctionnement.

15. Arrangement selon la revendication 14, dans lequel le rotor de pompe (92) est en interaction avec la roue de ventilateur (64) par l'intermédiaire d'un entrefer pour entraîner celle-ci à la manière d'un accouplement magnétique.

16. Arrangement selon l'une des revendications précédentes, dans lequel l'arbre (46') du rotor (26) est monté dans un palier fritté (130) qui est fixé dans un tube support (132) qui est lui-même fixé dans le tube palier (134) qui est disposé sur l'élément séparateur non-ferromagnétique (80', 82).

17. Arrangement selon la revendication 16, dans lequel, dans la zone de l'extrémité libre de l'arbre (46') qui dépasse du palier fritté (130), il est prévu un élément d'arrêt (59') qui assure l'arbre (46') contre un retrait du palier fritté (130).

18. Arrangement selon la revendication 16 ou 17, dans lequel une calotte est prévue à l'extrémité libre de l'arbre (46').

19. Arrangement selon l'une des revendications 14 à 18, dans lequel le stator intérieur (22') disposé sur le tube palier (134) présente un corps de bobine (140) qui est réalisé en tant que dispositif d'arrêt ou de sécurité pour le tube support (132).

20. Arrangement selon l'une des revendications 16 à 19, dans lequel le tube support (132) est pourvu sur son côté extérieur de nervures (138) qui sont réalisées pour se déformer lors de l'enfoncement du tube support (132) dans le tube palier (134).

21. Arrangement selon l'une des revendications 1 à 15, dans lequel, pour le montage de l'arbre (46) du rotor (26 ; 92), il est prévu des paliers à roulement (48, 50) entre les bagues extérieures (48e, 50e) desquels est disposé un élément d'écartement (53) et à l'intérieur des bagues intérieures (48i, 50i) desquels cet arbre (46) est disposé de manière à pouvoir coulisser axialement.

22. Arrangement selon la revendication 21, dans lequel, à l'extrémité libre de l'arbre (52), il est prévu un élément d'arrêt ou de sécurité (59) qui, à l'état monté, s'applique contre la bague intérieure (50i) d'un palier à roulement (50) voisin.

23. Arrangement selon la revendication 22, dans lequel il est prévu un ressort (48) qui presse l'élément d'arrêt ou de sécurité (59) avec précontrainte contre la bague intérieure (50i) du palier à roulement (50) voisin.

24. Arrangement selon l'une des revendications 21 à 23, dans lequel la bague extérieure (48e) d'un des paliers à roulement (48, 50) est immobilisée dans le tube palier (30) par un élément d'arrêt ou de sécurité (54).
